Europäisches Patentamt

European Patent Office

Office européen des brevets

(11) Publication number: **0 050 393**
A2

(12) **EUROPEAN PATENT APPLICATION**

(21) Application number: **81201158.3**

(22) Date of filing: **20.10.81**

(51) Int. Cl.³: **H 01 P 3/02**, H 01 P 5/08, H 03 D 9/04

(30) Priority: **22.10.80 GB 8034066**

(43) Date of publication of application: **28.04.82**
**Bulletin 82/17**

(84) Designated Contracting States: **BE DE FR GB IT SE**

(71) Applicant: **PHILIPS ELECTRONIC AND ASSOCIATED INDUSTRIES LIMITED, ARUNDEL GREAT COURT 8 Arundel Street, London WC2R 3DT (GB)**

(84) Designated Contracting States: **GB**

(71) Applicant: **N.V. Philips' Gloeilampenfabrieken, Pieter Zeemanstraat 6, NL-5621 CT Eindhoven (NL)**

(84) Designated Contracting States: **BE DE FR IT SE**

(72) Inventor: **Bates, Robert Neil, c/o PHILIPS RESEARCH LABORATORIES, Redhill Surrey RH1 5HA (GB)**

(74) Representative: **Boxall, Robin John et al, Philips Electronic and Associated Ind. Ltd. Patent Department Mullard House Torrington Place, London WC1E 7HD (GB)**

(54) Finline circuit configuration.

(57) To provide a microwave finline configuration which has no equivalent in unilateral finline, two different finline circuits extend in a common length of waveguide (1, 2), suitably on opposite major surfaces of a common dielectric substrate (3). A pair of Doppler mixers may have identical finline circuit patterns formed by sheet conductors (4 and 5, 6 and 7) with identical mixer diodes (10, 11) connected across their respective fin transmission lines, the finline circuits differing in the longitudinal positions of the diodes (10, 11), which positions are such as to provide respective beat-frequency output signals, via low-pass filters (12, 13), in phase quadrature.

0050393

"FINLINE CIRCUIT CONFIGURATION"


This invention relates to finline circuit configurations.

Finline circuits are used in the propagation of electromagnetic waves at microwave frequencies, and are particularly useful at millimetric wavelengths at which other propagation means may have significant disadvantages; for example, the dimensions associated with microstrip may be inconveniently small, and with regard to waveguide, it may be difficult to mount in a waveguide semiconductor devices with parasitic reactances which are suitably small for such high frequencies.  Finline comprises a waveguide with a plurality of sheet conductors that extend along the waveguide and that have spaced, opposed edges defining a slot or gap.  An electromagnetic wave can propagate along this structure with an electric field maximum across the gap;  at least one pair of sheet conductors is required to define one fin transmission line.  The sheet conductors generally extend in a common plane, and they may be self-supporting (see, for example, U.S. Patent 2,923,901) or be supported on one or both major  surfaces of a dielectric substrate (see, for example, Electronics Letters, Vol. 12, No. 17 (19th August, 1976), pp. 428-9).  In the proposed form known as bilateral finline, two identical finline circuits with identical finline circuit patterns are provided one on each major surface of a substrate to form two identical finline circuits which, being closely transversely spaced throughout, are coupled together throughout and effectively form a single finline circuit that has an analogy in unilateral finline.

The invention is associated with the concept of a configuration of two finline arrangements which are coupled together and which are somewhat analogous to bilateral finline in that they each extend in a common length of waveguide but which are nevertheless distinct in that they do not merely duplicate each other but instead together provide a configuration that has no analogy in unilateral finline; they may, for example, be self-supporting but may suitably be formed,

0050393

like bilateral finline, on opposite major surfaces of a dielectric substrate, and the coupling between them may, as in bilateral finline, be due to their being closely transversely spaced.

According to a first aspect, the invention provides a configuration of two non-coplanar finline circuits comprising a common length of waveguide, the two circuits being closely transversely spaced over at least part of said common length so as to be coupled together, characterised in that in said common length the circuits differ from one another.

The invention enables the construction of finline devices which have no equivalent in known forms of finline and/or which are compact.

The two circuits may each comprise a respective fin transmission line, the two lines being closely transversely spaced in the common length at a respective end of each line and the two ends of the lines remote from one another forming respective ports of the finline configuration comprising the two lines. Such a configuration may be particularly compact.

As an alternative, the two circuits may each extend from one end of said common length to the other and be closely transversely spaced at each end so as to be coupled together.

The difference in the finline circuits may be due, at least in part, to a difference in the finline circuit patterns in said common length.

The circuits may comprise respective fin transmission lines and the same respective further circuit elements coupled thereto, the circuits differing in the positions at which the further circuit elements are coupled to their respective fin transmission lines. The further circuit elements may both be finline circuit elements (in which case the finline circuit patterns differ), or they may both be another kind of circuit element operating in the same frequency range as the fin transmission line, such as a different form of transmission line or a semiconductor device.

Suitably, the two circuits are isolated from each other in a range of frequencies below that at which microwaves can propagate along the common length of waveguide.

According to a second aspect, the invention provides a configuration of two non-coplanar finline mixer circuits comprising a common length of waveguide and each comprising a respective fin transmission line and a respective mixer diode coupled thereto in said common length, wherein the fin transmission lines are coupled together, and wherein the diodes are isolated from each other in a range of frequencies below that at which microwaves can propagate along the common length of waveguide. The range of frequencies at which the circuits are isolated from each other may be suitable for an intermediate frequency or may be audio frequencies. In both the latter case and in a configuration embodying the first aspect of the invention wherein the circuits are similarly isolated from each other, the circuits may form a pair of Doppler mixers, both circuits being adapted to receive a Doppler-shifted signal at one end of the common length and to receive a local-oscillator signal at the other end, and the relative positions of the diodes being such that their beat-frequency outputs are substantially in phase quadrature at an operating frequency of the mixers.

In a configuration embodying the first or second aspect of the invention, respective sets of sheet conductors with spaced opposed edges defining respective fin transmission lines of the two circuits may have any one or more of the following three features:-

(i) have two sheet conductors, one from each set, electrically connected together;

(ii) be in respective E-planes of a rectangular waveguide;

(iii) be on opposite major surfaces of a common substrate.

An embodiment of the invention will now be described, by way of example, with reference to the accompanying drawings which are schematic and not to scale and in which:-

Figure 1 is a longitudinal view of part of a Doppler mixer configuration embodying the invention, showing the pattern of sheet conductors on one major surface of a dielectric substrate and one half of a waveguide housing, and

Figure 2 is a transverse sectional view of the mixer configuration on the line II-II in Figure 1.

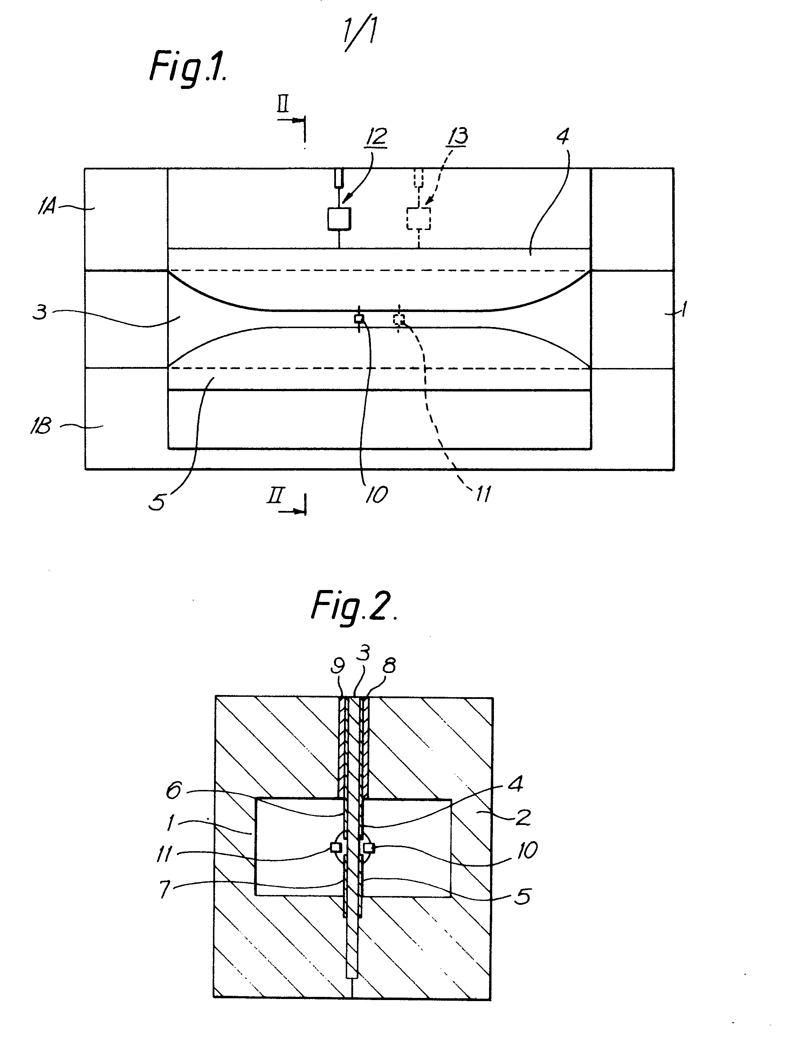

The configuration shown in the drawings is a pair of finline Doppler mixers providing output signals from which the direction of movement of a target relative to a radar system comprising the configuration can be determined. The configuration comprises two identical portions 1, 2 of a housing, forming a length of waveguide, with a dielectric substrate 3 clamped therebetween (by means not shown). The two major surfaces of the substrate 3 support different respective finline circuits. In this case, the circuits have identical finline circuit patterns, that on the upper surface of the substrate (as drawn in Figure 1) comprising two sheet conductors 4, 5 and that on the other surface comprising sheet conductors 6,7. The sheet conductors extend out of the waveguide between the faces of the housing 1, 2 which engage the substrate (such as faces 1A, 1B of portion 1); the lower conductors (as drawn) 5, 7 are in direct electrical contact with the engaging faces of the housing, while the upper conductors 4, 6 are separated therefrom by thin layers, 8 and 9 respectively, of dielectric material so that the upper conductors are coupled to the housing at microwave frequencies but isolated at lower frequencies. The extent to which the sheet conductors penetrate the housing is a quarter wavelength at the operating microwave frequency so as to provide an effective short-circuit to the housing at the broad walls of the waveguide. Each finline circuit comprises a respective fin transmission line, defined by adjacent but spaced opposed edges of its respective pair of sheet conductors, extending along the waveguide mid-way between its broad walls with a cosine-taper finline to waveguide transition at each end. Since the finline circuit patterns are identical, the finline circuits are coupled together throughout their length: the finline circuits in this case differ only in the positions at which two identical mixer diodes 10, 11 are connected across the respective fin transmission lines. Audio-frequency output signals are derived from the diodes via low-pass stripline filters 12, 13 each comprising alternately narrow and broad quarter-wavelength strip conductors terminating in, for example, a coaxial connector (not shown).

In operation, radar signals reflected from a moving target are supplied to one end of the waveguide and local-oscillator signals, usually derived from the same source as the transmitted signals, are supplied to the other end.  The longitudinal spacing of the diodes 10, 11 (nominally one eighth of a wavelength at the operating frequency) is such that the beat-frequency signals from the diodes are substantially in phase quadrature.

A mixer of the form described above has been constructed for operation at 35 GHz.  The housing 1, 2 was of aluminium, forming a waveguide of size WG 22; the substrate was RT duroid 5880 ( $\epsilon$ = 2.22) of 0.005 inches (127 µm) thickness with $\frac{1}{2}$ oz. copper cladding on each major surface, enabling the finline and stripline circuit patterns to be produced by printed-circuit techniques.  The width of the slot of the fin transmission line was 200 µm.  The diodes were AEI type DC 1308 beam lead gallium arsenide Schottky barrier devices.  The required longitudinal spacing of the diodes in practice differs from the nominal value of one eighth of a wavelength owing to the parasitic capacitance of the diodes.  Several pairs of mixers were constructed with different respective spacings, and the relative phases of the output signals measured for each pair; a suitable spacing of the diodes to provide a phase difference of $90^O \pm 20^O$ (required for an associated phase detector to give a reliable indication of the direction of movement) was found to be 690 µm.  The D.C. isolation of the diodes enabled them to be biased to desired parts of their characteristics.

It is not essential for the finline circuits patterns in embodiments of the invention to be identical: for example, the two respective sets of sheet conductors  need not be located symmetrically between the narrow walls of the waveguide, nor need each of the two respective fin transmission lines be located mid-way, or otherwise symmetrically, between the broad walls.  The circuits need not be coupled together throughout their length: in the mixer, it is only necessary for the circuits to be coupled to a first common input port for received echo signals and to a second input port for local-oscillator signals, and the coupling may therefore be other than by the close transverse spacing of respective fin transmission lines, for example by other forms of transmission line.

0050393

In configurations embodying the first aspect of the invention, it is not necessary for the finline circuits to be coupled together at one or both ends of the common length of waveguide. For example, a circuit configuration having a single port at each end of a length of waveguide may comprises a plurality of successive finline circuits which are alternately on opposite sides of a dielectric substrate and which are coupled one to the next by being closely transversely spaced.

CLAIMS:-

1.    A configuration of two non-coplanar finline circuits comprising a common length of waveguide, the two circuits being closely transversely spaced over at least part of said common length so as to be coupled together, characterised in that in said common length the circuits differ from one another.

2.    A configuration as claimed in Claim 1, wherein the two circuits each extend from one end of said common length to the other and are closely transversely spaced at each end so as to be coupled together.

3.    A configuration as claimed in Claim 1 or 2, wherein the finline circuit patterns differ in said common length.

4.    A configuration as claimed in any preceding claim wherein the circuits comprise respective fin transmission lines and the same respective further circuit elements coupled thereto, the circuits differing in the positions at which the further circuit elements are coupled to their respective fin transmission lines.

5.    A configuration as claimed in Claim 4, wherein the further circuit elements are semiconductor devices.

6.    A configuration as claimed in any proceding claim, wherein the two circuits are isolated from each other in a range of frequencies below that at which microwaves can propagate along the common length of waveguide.

7.    A configuration of two non-coplanar finline mixer circuits comprising a common length of waveguide and each comprising a respective fin transmission line and a respective mixer diode coupled thereto in said common length, wherein the fin transmission lines are coupled together, and wherein the diodes are isolated from each other in a range of frequencies below that at which microwaves can propagate along the common length of waveguide.

0050393

8. A configuration as claimed in Claim 7, wherein the circuits form a pair of Doppler mixers, both circuits being adapted to receive a Doppler-shifted signal at one end of the common length and to receive a local-oscillator signal at the other end, and the relative positions of the diodes being such that their beat-frequency outputs are substantially in phase quadrature at an operating frequency of the mixers.

9. A configuration as claimed in any preceding claim, wherein respective sets of sheet conductors with spaced opposed edges defining respective fin transmission lines of the two circuits have two sheet conductors, one from each set, electrically connected together.

10. A configuration as claimed in any preceding claim, wherein respective sets of sheet conductors with spaced opposed edges defining respective fin transmission lines of the two circuits are in respective E-planes of a rectangular waveguide.

11. A configuration as claimed in any preceding claim, wherein respective sets of sheet conductors with spaced opposed edges defining respective fin transmission lines of the two circuits are on opposite major surfaces of a common substrate.

*******************************

**Fig.1.**

**Fig.2.**